# EUROPÄISCHE PATENTSCHRIFT

(11) **EP 3 632 196 B1**
(45) Veröffentlichungstag und Bekanntmachung des Hinweises auf die Patenterteilung: **21.04.2021**
(21) Anmeldenummer: 18732642.6
(22) Anmeldetag: 17.05.2018
(51) Int. Cl.: H05K 7/14, G01D 11/24, G01D 21/00

(54) **MODULAR AUFGEBAUTES FELDGERÄT**
FIELD DEVICE OF MODULAR CONSTRUCTION
APPAREIL DE TERRAIN À STRUCTURE MODULAIRE

(30) Priorität: 31.05.2017 DE 102017111998
(43) Veröffentlichungstag der Anmeldung: 08.04.2020
(73) Patentinhaber: Robodev GmbH, 76135 Karlsruhe (DE)
(72) Erfinder: BIHLMAIER, Andreas, 76137 Karlsruhe (DE); MINTENBECK, Julien, 76228 Karlsruhe (DE); LIEDKE, Jens, 76131 Karlsruhe (DE)
(74) Vertreter: Geitz Truckenmüller Lucht Christ
(86) Internationale Anmeldenummer: PCT/DE2018/100478
(87) Internationale Veröffentlichungsnummer: WO 2018/219400

(56) Entgegenhaltungen:
- EP-A2- 0 902 346
- DE-A1-102015 107 306
- DE-B3-102006 019 555
- US-A1- 2005 288 799
- US-A1- 2006 232 940
- US-A1- 2007 057 783

## Beschreibung

Die vorliegende Erfindung betrifft ein modular aufgebautes Feldgerät zum Betrieb an einem Feldbus, umfassend ein Gehäuse mit einem Basismodul, welches eine Recheneinheit zur Prozesssteuerung, eine mit der Recheneinheit datenverbundene Kommunikationsschnittstelle zur Verbindung mit einem lokalen Kommunikationsnetz, sowie eine mit einer Spannungsversorgung der Recheneinheit elektrisch verbundene elektrische Schnittstelle zur Verbindung mit einem lokalen Spannungsnetz aufweist.

Ein derartiges Feldgerät ist bereits aus der US 2007 / 0 057 783 A1 vorbekannt. Aus dieser Schrift ist ein Feldgerät zum Betrieb an einem Feldbus vorbekannt, umfassend ein Gehäuse mit einem Basismodul, welches eine Rechnereinheit zur Prozesssteuerung, eine mit der Rechnereinheit datenverbundene Kommunikationsschnittstelle zur Verbindung mit einem lokalen Kommunikationsnetz, sowie eine mit der Spannungsversorgung der Rechnereinheit elektrisch verbundene Schnittstelle, nämlich eine Ethernet-Schnittstelle aufweist. Das vorbekannte Basismodul ist dabei so ertüchtigt, dass es mit einer Vielzahl unterschiedlicher Funktionsmodule kombiniert werden kann. Allerdings ist das aus diesem Stand der Technik vorbekannte Feldgerät in einem eigenen, sicheren Gehäuse aufgenommen, nämlich explosionsgeschützt.

Ein Feldgerät mit ähnlicher Funktionalität ist auch aus der US 2005 / 0 288 799 A1 vorbekannt.

Außerdem ist in diesem Zusammenhang ein Gehäuse aus der US 2006 / 0 232 940 A1 vorbekannt, wobei dieses Gehäuse in Form eines, einen Innenhohlraum umschließenden, Mehrkantprofils gestaltet ist. Dabei ragt ein an einer Basisplatte befestigtes Basismodul endständig in diesen Innenhohlraum derart ein, dass der besagte Innenhohlraum mit der Basisplatte verschlossen ist.

Ferner ist auch aus der DE 10 2014 109 783 A1 ein Gehäuse vorbekannt, dass als einen Innenhohlraum umschließendes Mehrkantprofil ausgestaltet ist. Auch in diesen Innenhohlraum ragt ein an einer Basisplatte befestigtes Basismodul endständig derart ein, dass der Innenhohlraum ebenfalls mit der besagten Basisplatte verschlossen ist.

Derartige Feldgeräte sind im Stand der Technik bereits weitgehend bekannt und üblich. Im Feldbetrieb erfassen sie Daten und Zustände, regeln oder steuern Prozesse und leiten Messergebnisse an Prozessrechner weiter oder verarbeiten diese direkt weiter. Sie sind in aller Regel spezifisch ausgestaltet und ihrem Einsatzzweck im Feld entsprechend hergerichtet. So wird etwa für Überwachungsaufgaben eine Kamera, für eine Temperaturmessung ein Messfühler, für eine hydraulische Regelungsaufgabe ein Stellventil eingesetzt. Je nach verwendetem Bussystem müssen häufig diese Komponenten noch speziell hergerichtet werden, um über den Bus kommunizieren zu können.

Auch ist es erforderlich, für die einzelnen Komponenten jeweils vor Ort eine Spannungsversorgung bereitzustellen, was bedeuten kann, dass eine Netzspannung bereitgehalten wird, an der für jedes einzelne Gerät ein für dessen Anforderungen passender Spannungswandler Einsatz findet. Die einzelnen Geräte sind in den seltensten Fällen gegeneinander austauschbar und im Falle eines Geräteausfalls muss das komplette Gerät durch ein anderes ersetzt werden. Dies möchte der Betreiber allerdings schon aus Kostengründen vermeiden, der ansonsten gezwungen ist, unterschiedlichste Geräte vorzuhalten, für den Fall, dass diese benötigt werden könnten.

Um Prozesse innerhalb der Automatisierungsumgebung zu steuern, sind in der Regel zusätzlich Steuereinheiten mit Mikroprozessoren erforderlich, die mit dem Prozessrechner kommunizieren und dessen komplexen Anweisungen in Steuerbefehle für die einzelnen Feldgeräte umsetzen, sowie auf dem umgekehrten Weg die ermittelten Messwerte für den Prozessrechner aufbereiten oder zu komplexeren Zwischenergebnissen zusammenführen.

Vor diesem Hintergrund liegt der vorliegenden Erfindung die Aufgabe zu Grunde, ein modulares Feldgerät zu schaffen, welches einen hohen Grad an Modularisierung aufweist und es ermöglicht, weitgehend auf standardisierte Komponenten zurückzugreifen. Hierbei soll nicht nur ein technisches Zusammenspiel zwischen den Komponenten funktionieren, sondern auch eine räumliche Integration erfolgen, um den Aufwand der Verkabelung sowie den logistischen Aufwand der Lagerung und Bereitstellung möglichst weit zu senken.

Dies gelingt durch ein Feldgerät gemäß den Merkmalen des Anspruchs 1. Weitere sinnvolle Ausgestaltungen eines solchen Feldgeräts können den Unteransprüchen entnommen werden.

Erfindungsgemäß ist vorgesehen, dass ein Feldgerät ein gemeinsames Gehäuse aufweist, in dem alle erforderlichen Komponenten des Feldgeräts aufgenommen werden können. Hierzu ist es vorgesehen, dass ein solches Feldgerät über ein Basismodul verfügt, welchem eine Recheneinheit, eine Kommunikationseinheit und eine Spannungsversorgung zugeordnet sind. Mit einem solchen Basismodul ist jedes Feldgerät ausgestattet, so dass sowohl die Kommunikation über den Feldbus, als auch die Spannungsversorgung sichergestellt ist und das Gerät angesprochen wird und Daten übermitteln kann. Hiervon ausgehend sieht die Erfindung vor, dass das Aufbauprinzip eines solchen Feldgeräts auf einem Gehäuse aus einem Mehrkantprofil aufbaut, welches in einem leeren Zustand von zwei Seiten her verschlossen werden kann. So ist das Basismodul derart aufgebaut, dass es auf einer Basisplatte montiert ist, die von einer Seite her in das Mehrkantprofil eingeschoben wird und diese gleichzeitig verschließt.

Selbstverständlich kann die Basisplatte hierfür von Anschlüssen, Sicht- und Kommunikationsfenstern jedweder Art durchgriffen werden, jedoch findet der Aufbau des Basismoduls stets gleich und stets auf der an die Form des Mehrkantprofils angepasste Basisplatte statt. In dieser Konfiguration steht bereits die Recheneinheit für Aufgaben aus der Automatisierungsumgebung zur Verfügung. Aufgrund dieser einheitlichen Bestückung eines solchen Mehrkantprofils mit den Basismodulen, welche eine einheitliche Kommunikationsplattform schaffen und eine einheitliche Spannungsversorgung gewährleisten, kann sichergestellt werden, dass alle Feldgeräte die gleiche Basis haben und damit bei Ausfällen nur einheitliche Komponenten ausgetauscht werden müssen. Auf spezielle Geräte kann damit verzichtet werden. Eine Spezialisierung der bis dahin noch auf reine Rechenaufgaben beschränkten Basis-Feldgeräte kann nach Bedarf durch ein Hinzufügen von Funktionsmodulen erfolgen. Diese Funktionsmodule umfassen Funktionseinheiten unterschiedlichster Art, die auf einer Deckelplatte, komplementär zur Basisplatte, auf der noch freien Seite des Mehrkantprofils in dieses eingebracht werden und das Mehrkantprofil somit vollständig verschließen. Beim Einsetzen des Funktionsmoduls in das Mehrkantprofil wird die Funktionseinheit sowohl mit der Spannungsversorgung des Basismoduls verbunden, als auch eine Datenverbindung mit der Recheneinheit aufbauen, über die eine Steuerung der Funktionseinheit durch die Recheneinheit erfolgen kann. Analog zur Basisplatte kann auch die Deckelplatte von dem wenigstens einen Funktionselement durchgriffen sein, Fenster oder Öffnungen aufweisen, durch welche das Funktionselement hindurchwirken kann, oder geeignete Adapter, Anschlüsse, Flanschs und des Weiteren mehr aufweisen, ganz in Abhängigkeit von der Art und Funktionalität des wenigstens einen Funktionselements.

Im Einzelnen kann ein solches Funktionselement etwa ein Motor, ein Sensor oder eine Sensoranordnung, ein Beleuchtungselement, eine Kamera, eine Arbeitsmaschine, ein Eingabeelement, ein Display oder ein Lautsprecher sein. , Um den Feldbus zu steuern und die Spannung einzuspeisen, sowie um eine Kommunikation mit Geräten außerhalb eines lokalen Kommunikationsnetzes, etwa über das Internet, zu ermöglichen, wird eine Art Kopfstation benötigt, welche neben dem Basismodul auch eine mit der Recheneinheit datenverbundene Netzwerkschnittstelle zur Verbindung mit diesem externen Kommunikationsnetz aufweist. Die Kopfstation stellt in diesem Zusammenhang das Tor zu dem externen Netzwerk dar und kann die Kommunikation zwischen externen Geräten und den einzelnen Feldgeräten steuern und bedarfsweise beschränken. Auch verbindet sie über den mit der Spannungsversorgung der Recheneinheit elektrisch verbundenen Netzanschluss ein öffentliches Energienetz mit dem internen Spannungsnetz der Feldgeräte, so dass diesen eine gemeinsame Netzspannung zur Verfügung steht. Die Vorgabe der Spannung auf dem internen Spannungsnetz erfolgt über einen Spannungswandler, welcher zwischen den Netzanschluss der Kopfstation und die Spannungsversorgung der Recheneinheit zwischengeschaltet ist.

Mit einigem Vorteil handelt es sich bei dem Gehäuse um ein langgestrecktes Mehrkantprofil, vorzugsweise ein Dreikant- oder Vierkantprofil, welches zudem auf seiner Umfangswandung wenigstens eine hinter-schnittene Längsnut aufweist. In diese kann zur Befestigung des Feldgeräts an einer Tragvorrichtung ein Nutenstein eingeführt werden, in welchen eine Schraube eingedreht werden und das Gehäuse an der Tragvorrichtung, etwa in Form eines Trägerprofils, einer Traverse oder eines Standgerüsts, fixiert werden kann.

Die erfindungsgemäße Lösung hat jedoch auch im Hinblick auf die Kühlung einige Vorteile. Zunächst werden im Basismodul oder dem Funktionsmodul Niederspannungen von vorzugsweise 48 Volt, jedenfalls einer Spannungsebene im Bereich der Kleinstspannung eingesetzt, so dass die Wärmeentwicklung vergleichsweise klein ist. Dann können außerdem Mikroprozessoren eingesetzt werden, die energieeffizient arbeiten und damit lediglich eine geringe Leistungsaufnahme besitzen und nur geringen Platzbedarf haben und damit eine geringe Abwärme produzieren. Die dennoch produzierte Abwärme kann durch eine Kontaktierung einer Heißseite des Mikroprozessors an der Basisplatte oder der Deckelplatte, vorzugsweise unter Zwischenlage einer wärmeleitenden Schicht, in das Gehäuse abgeführt werden. Die Deckelplatte und/oder die Basisplatte sind hierfür aus einem wärmeleitenden Material, vorzugsweise aus Metall und höchst vorzugsweise aus Aluminium oder Kupfer hergestellt. Ferner können die Basisplatte und/oder die Deckelplatte zusätzlich wärmeleitend mit dem ebenfalls wärmeleitenden Mehrkantprofil verbunden sein, so dass auch dessen Außenfläche zur Kühlung der Prozessoren zur Verfügung steht. Schrauben, mit denen die Deckelplatte und/oder die Basisplatte mit dem Mehrkantprofil verbunden sind, können insbesondere die Wärme aus diesen Platten in das Mehrkantprofil ableiten.

Alternativ kann der Ableitprozess der Prozessorabwärme auch auf dem Umgekehrten Weg erfolgen. Wird ein Wärmeübergang, etwa in Form eines wärmeleitenden Materialabschnitts, an der Innenwand des Mehrkantprofils angeordnet und kontaktiert die Heißseite des Prozessors diesen Wärmeübergang, so kann die Wärme zunächst in das Mehrkantprofil abfließen und bedarfsweise zusätzlich über die Schrauben in die Basisplatte und/oder die Deckelplatte.

Für die Kommunikation in der Automatisierungsumgebung wird das Protokoll Ethernet POWERLINK, bzw. ein anderes Ethernet-basiertes Echtzeitprotokoll, bevorzugt. Hinsichtlich des lokalen, internen Spannungsnetzes kommt vorzugsweise ein Niederspannungsnetz zum Einsatz. Bedarfsweise können die zugehörigen Schnittstellen des Basismoduls hierbei zu einer hybriden Schnittstelle zusammengezogen werden, wobei etwa auch ein bekanntes Protokoll wie Power-over-Ethernet (PoE) zum Einsatz kommen kann.

Die vorstehend beschriebene Erfindung wird im Folgenden anhand eines Ausführungsbeispiels näher erläutert.

Es zeigen
- Figur 1: ein erfindungsgemäßes Feldgerät in einer perspektivischen Darstellung von schräg oben,
- Figur 2: einen seitlichen Querschnitt des Feldgeräts gemäß Figur 1 in einer schematischen Blockdarstellung,
- Figur 3: eine Variante des Feldgeräts gemäß Figur 5 in einer schematischen Blockdarstellung,
- Figur 4: ein Detail eines seitlichen Querschnitts des Feldgeräts gemäß Figur 1, sowie
- Figur 5: ein Detail einer Querschnitts-Draufsicht des Feldgeräts gemäß Figur 1.

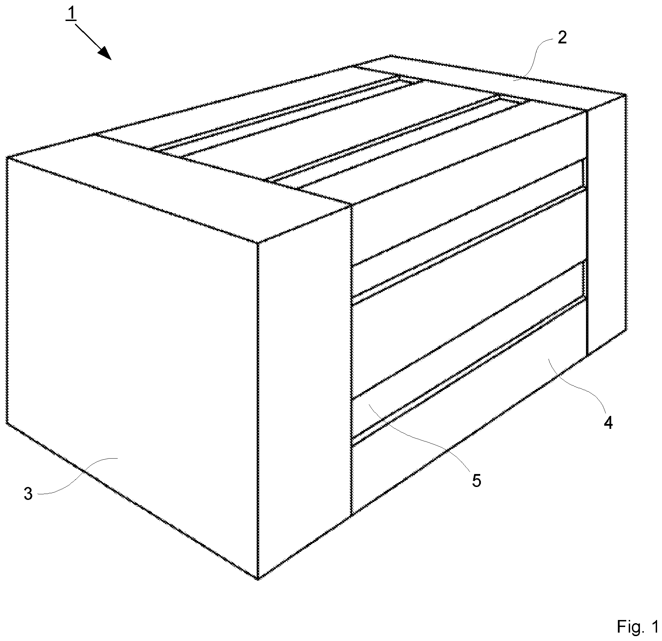

Figur 1 zeigt ein Feldgerät 6, welches in einem modular aufgebauten Gehäuse 1 angeordnet ist. Das Gehäuse 1 besteht im Wesentlichen aus einem langgestreckten Vierkantprofil 4, welches an jeder seiner Seitenflächen zwei hinterschnittene Längsnuten 5 zur Montage an einer hier nicht dargestellt und nicht weiter interessierenden Trägerstruktur aufweist. Abgeschlossen wird das Vierkantprofil 4 an beiden Enden mithilfe von Platten, welche die in dem Feldgerät 6 realisierten Funktionselemente 8 und die Elemente eines Basismoduls 9 tragen. Es handelt sich um eine Basisplatte 2, welche das Basismodul 9 trägt, sowie eine Deckelplatte 3, auf der ein Funktionsmodul 7 mit wenigstens einem Funktionselement 8 angeordnet ist.

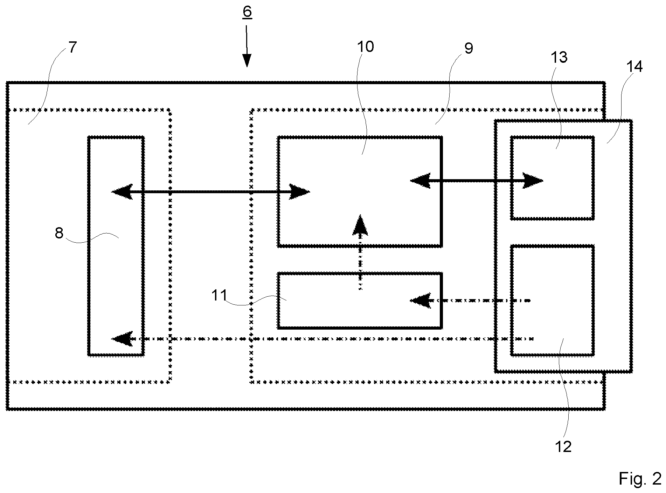

Figur 2 zeigt schematisch den inneren Aufbau des Feldgeräts 6. von der linken Seite her wird das Funktionsmodul 7 mit den auf der Deckelplatte 3 montierten Funktionselementen 8, beispielsweise einer Leuchte, in das Vierkantprofil eingeführt, während von der rechten Seite her das Basismodul 9 eingeschoben wird. Das Basismodul 9, das bei jedem Feldgerät vorhanden ist, umfasst zunächst und zuvorderst eine Recheneinheit 10, welche mit dem wenigstens einen Funktionselement 8 Daten über eine drahtgebundene oder eine drahtlose Verbindung austauscht. die Recheneinheit 10 wird von einer Spannungsversorgung 11 mit einer Niederspannung von 48 Volt versorgt, die über eine elektrische Schnittstelle 12, innerhalb einer hybriden Schnittstelle 14, anliegt. Die elektrische Schnittstelle 12 versorgt ferner auch das wenigstens eine Funktionselement 8 des Funktionsmoduls 7. Die hybride Schnittstelle 14 umfasst neben dieser elektrischen Schnittstelle 12 auch eine Kommunikationsschnittstelle 13, mit welcher innerhalb des lokalen Netzes der Automatisierungsumgebung unter den Feldgeräten Daten ausgetauscht werden können.

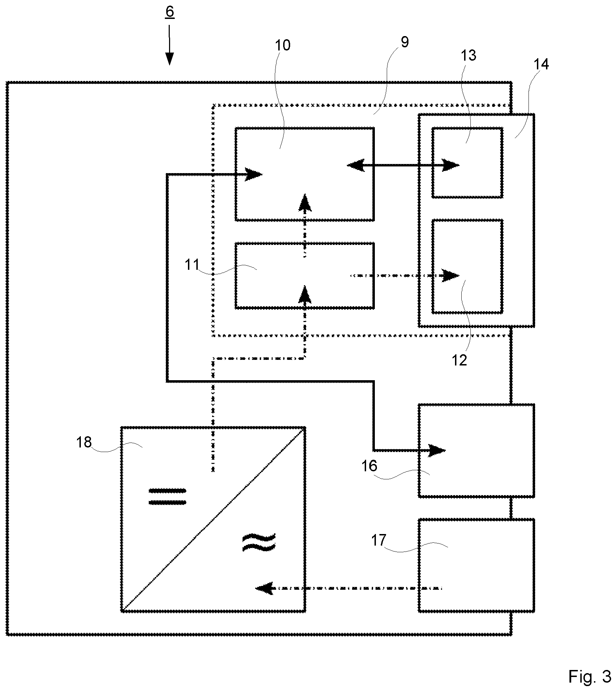

In Figur 3 ist eine Variante des vorstehend beschriebenen Feldgeräts beschrieben, welche in Bezug auf die Automatisierungsumgebung eine Kopfstation darstellt. Diese umfasst kein Funktionsmodul 8, dafür jedoch zusätzlich eine Netzwerkschnittstelle 16 und einen Netzanschluss 17. Über den Netzanschluss 17 liegt eine Netzspannung von 220 Volt an einem Spannungswandler 18 an, welcher die anliegende Wechselspannung von 220 Volt, bzw. in den USA 110 Volt, in eine Gleichspannung von 48 Volt umsetzt. Diese 48 Volt Gleichspannung liegen an der Spannungsversorgung 11 der Recheneinheit 10 an und werden auch in die elektrische Schnittstelle 12 eingespeist, welche ebenfalls in dem bereits bekannten und auch hier vorhandenen Basismodul 9 vorgesehen ist.

Zusätzlich kommuniziert hier die Recheneinheit 10 mit der Netzwerkschnittstelle 16 und nimmt Anfragen von einem externen Netz, etwa dem Internet, entgegen und sendet Datenpakete aus dem internen Netz heraus.

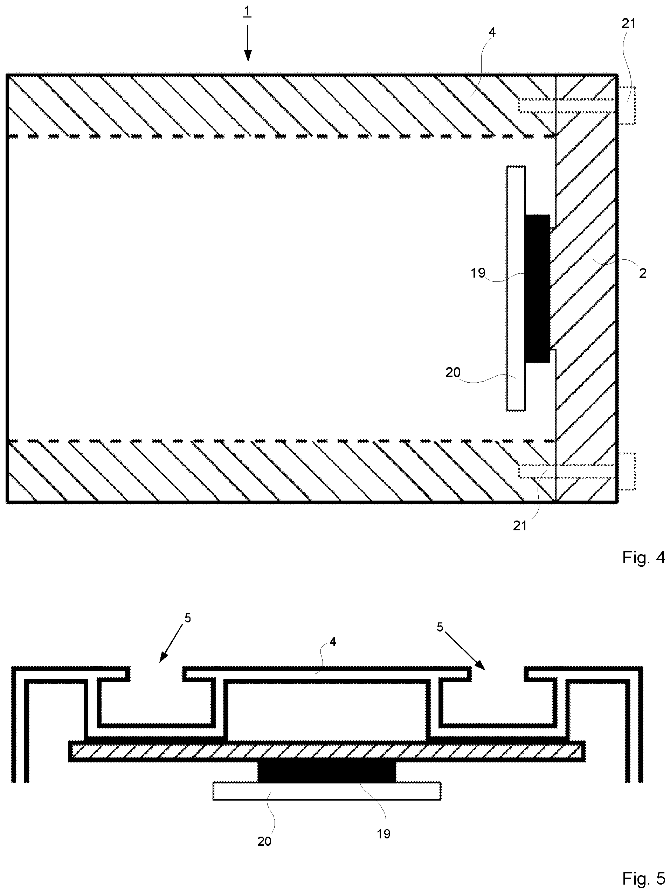

Figur 4 zeigt einen anderen Aspekt der Erfindung in einem Detailausschnitt eines Querschnitts durch das Gehäuse 1. Ein auf einer Leiterplatte 20 verbauter Mikroprozessor 19, der eine Recheneinheit 10 der Figur 2 realisiert, ist über einen wärmeleitenden Kontakt auf der Basisplatte 2 befestigt und leitet anfallende Abwärme über seine Heißseite direkt in die Basisplatte 2 ein. Die Basisplatte ihrerseits ist über Wärmeübergänge 21, hier als Schrauben ausgeführt, mit dem Vierkantprofil 4 des Gehäuses 1 verbunden, so dass zusätzlich eine Weiterleitung der Wärme an der Basisplatte 2 an das Vierkantprofil erfolgen kann. Die betroffenen Gehäuseteile 2 und 4 sind dabei aus einem wärmeleitenden Material hergestellt.

Figur 5 zeigt eine Alternative zu der vorangegangenen Figur 4, bei welcher der auf einer Leiterplatte 20 montierte Mikroprozessor 19 über einen Wärmeübergang 21 in Form einer wärmeleitenden Platte direkt an dem Vierkantprofil 4, genauer an der Rückseite der Längsnuten 5, kontaktiert. Hierdurch wird die Wärme direkt in das Vierkantprofil 4 eingeleitet und dort verteilt, so dass eine große Oberfläche zur Ableitung zur Verfügung steht. Ferner kann auch auf dem Umgekehrten Weg die Wärme über die Montageschrauben in die Deckelplatte 3 und/oder die Basisplatte 2 abgeführt werden.

Vorstehend beschrieben ist somit ein modulares Feldgerät, welches durch die Bauform seines Gehäuses in einem Mehrkantprofil einen hohen Grad an Modularisierung aufweist und es ermöglicht, weitgehend auf standardisierte Komponenten in Form eines Basismoduls und variabler Funktionsmodule zurückzugreifen.

### BEZUGSZEICHENLISTE

- 1: Gehäuse
- 2: Basisplatte
- 3: Deckelplatte
- 4: Vierkantprofil
- 5: Längsnut
- 6: Feldgerät
- 7: Funktionsmodul
- 8: Funktionseinheit
- 9: Basismodul
- 10: Recheneinheit
- 11: Spannungsversorgung
- 12: elektrische Schnittstelle
- 13: Kommunikationsschnittstelle
- 14: hybride Schnittstelle
- 15: Kopfstation
- 16: Netzwerkschnittstelle
- 17: Netzanschluss
- 18: Spannungswandler
- 19: Mikroprozessor
- 20: Leiterplatte
- 21: Wärmeübergang

## Patentansprüche

1. Modular aufgebautes Feldgerät zum Betrieb an einem Feldbus, umfassend ein Gehäuse (1) mit einem Basismodul (9), welches eine Recheneinheit (10) zur Prozesssteuerung, eine mit der Recheneinheit (10) datenverbundene Kommunikationsschnittstelle (13) zur Verbindung mit einem lokalen Kommunikationsnetz der Automatisierungsumgebung des Feldgerätes, sowie eine mit einer Spannungsversorgung (11) der Recheneinheit (10) elektrisch verbundene elektrische Schnittstelle (12) zur Verbindung mit einem lokalen Spannungsnetz aufweist, wobei dem Gehäuse (1) ein Funktionsmodul (7) zugeordnet ist, welches wenigstens ein Funktionselement (8) aufweist, das mit der Recheneinheit (10) datenverbunden und mit der elektrischen Schnittstelle (12) elektrisch verbunden ist, so dass sowohl die Kommunikation über den Feldbus, als auch die Spannungsversorgung des Funktionsmoduls (7) sichergestellt ist, wobei das wenigstens eine Funktionselement (8) ein Motor, ein Sensor oder eine Sensoranordnung, ein Beleuchtungselement, eine Kamera, eine Arbeitsmaschine, ein Eingabeelement, ein Display oder ein Lautsprecher ist und wobei die mit der Recheneinheit (10) datenverbundene Kommunikationsschnittstelle (13) zur Verbindung mit einem lokalen Kommunikationsnetz, sowie die mit einer Spannungsversorgung (11) der Recheneinheit (10) elektrisch verbundene elektrische Schnittstelle (12) zur Verbindung mit einem lokalen Spannungsnetz in einer gemeinsamen hybriden Schnittstelle (14), vorzugsweise einer Power-over-Ethernet (PoE-)-Schnittstelle, zusammengefasst sind, **dadurch gekennzeichnet, dass** das Gehäuse (1) als einen Innenhohlraum umschließendes, langgestrecktes Mehrkantprofil (4) ausgestaltet ist, in dessen Innenhohlraum das an einer Basisplatte (2) befestigte Basismodul (9) endständig einragt und diesen mittels der Basisplatte (2) verschließt, wobei das wenigstens eine Funktionselement (8) an einer Deckelplatte (3) befestigt ist, wobei das Funktionsmodul (7) endständig in den Innenhohlraum des Mehrkantprofils (4) einragt und diesen mittels der Deckelplatte (3) verschließt und wobei das Mehrkantprofil (4) auf seiner Umfangswandung wenigstens eine hinterschnittene Längsnut (5) aufweist, in welche zur Befestigung des Feldgeräts (6) an einer Tragvorrichtung ein Nutenstein einführbar ist, in welchen eine Schraube eingedreht werden und das Gehäuse an der Tragvorrichtung fixiert werden kann.

2. Feldgerät gemäß einem der vorhergehenden Ansprüche, **dadurch gekennzeichnet, dass** dem Gehäuse (1) eine mit der Recheneinheit (10) datenverbundene Netzwerkschnittstelle (16) zur Verbindung mit einem externen Kommunikationsnetz, sowie einen mit der Spannungsversorgung (11) der Recheneinheit (10) elektrisch verbundenen Netzanschluss (17) zur Verbindung mit einem externen Spannungsnetz aufweist, wobei dem Netzanschluss (17) und der Spannungsversorgung (11) der Recheneinheit (10) ein Spannungswandler (18) zwischengeschaltet ist.

3. Feldgerät gemäß einem der vorhergehenden Ansprüche, **dadurch gekennzeichnet, dass** Mikroprozessoren (19) des Basismoduls (9) und/oder des Funktionsmoduls (7) mit der Basisplatte (2) und/oder der Deckelplatte (3) wärmeleitend verbunden sind und die Basisplatte (2) und/oder die Deckelplatte (3) ihrerseits wärmeleitend mit dem Mehrkantprofil (4) verbunden ist.

4. Feldgerät gemäß einem der vorhergehenden Ansprüche, **dadurch gekennzeichnet, dass** das Gehäuse (1) Mikroprozessoren (19) zugeordnet sind, welche unter Zwischenlage einer wärmeleitenden Schicht mit dem Mehrkantprofil (4) verbunden sind.

## Claims

1. A modularly constructed field device for operation on a field bus, comprising a housing (1) having a base module (9), which includes a processing unit (10) for process control, a communication interface (13), having a data connection to the processing unit (10), for connection to a local communication network of the automation environment of the field device, and an electrical interface (12), electrically connected to a power supply (11) of the processing unit (10), for connection to a local power grid, wherein a functional module (7) is associated with the housing (1), which includes at least one functional element (8), which has a data connection to the processing unit (10) and an electrical connection to the electrical interface (12), so that both the communication via the field bus and also the power supply of the functional module (7) are ensured, wherein the at least one functional element (8) is a motor, a sensor or a sensor arrangement, an illumination element, a camera, a work machine, an input element, a display, or a loudspeaker, and wherein the communication interface (13), having a data connection to the processing unit (10), for connection to a local communication network, and also the electrical interface (12), having an electrical connection to a power supply (11) of the processing unit (10), for connection to a local power grid are combined into a shared hybrid interface (14), preferably a Power-over-Ethernet (PoE) interface,
**characterized in that** the housing (1) is designed as an elongated polygonal profile (4) enclosing an inner cavity, into the inner cavity of which the base module (9) fastened on a base plate (2) protrudes at the end and closes it by means of the base plate (2), wherein the at least one functional element (8) is fastened on a cover plate (3), wherein the functional module (7) protrudes at the end into the inner cavity of the polygonal profile (4) and closes it by means of the cover plate (3) and wherein the polygonal profile (4) includes at least one undercut longitudinal groove (5) on its circumferential wall, in which a groove block is insertable for fastening of the field device (6) on a support device, into which groove block a screw can be screwed and the housing can be fixed on the support device.

2. The field device according to any one of the preceding claims, **characterized in that** the housing (1) includes a network interface (16), having a data connection to the processing unit (10), for connection to an external communication network, and a grid connection (17), electrically connected to the power supply (11) of the processing unit (10), for connection to an external power grid, wherein a voltage converter (18) is connected between the grid connection (17) and the power supply (11) of the processing unit (10).

3. The field device according to any one of the preceding claims, **characterized in that** microprocessors (19) of the base module (9) and/or the functional module (7) are connected in a heat-conducting manner to the base plate (2) and/or the cover plate (3) and the base plate (2) and/or the cover plate (3) is in turn connected in a heat-conducting manner to the polygonal profile (4).

4. The field device according to any one of the preceding claims, **characterized in that** microprocessors (19) are associated with the housing (1), which are connected to the polygonal profile (4) with a heat-conductive layer interposed.

## Revendications

1. Appareil de terrain modulaire pour utilisation sur un bus de terrain, comprenant un boîtier (1) avec un module de base (9) qui comprend une unité de calcul (10) pour la commande de processus, une interface de communication (13) connectée à l'unité de calcul (10) en vue de la transmission de données et servant à la connexion à un réseau de communication local de l'environnement d'automatismes de l'appareil de terrain, ainsi qu'une interface électrique (12) connectée électriquement à une alimentation électrique (11) de l'unité de calcul (10) et servant à la connexion à un réseau électrique local, dans lequel le boîtier (1) est associé à un module fonctionnel (7) comprenant au moins un élément fonctionnel (8) connecté à l'unité de calcul (10) en vue de la transmission de données et connecté électriquement à l'interface électrique (12), de façon à assurer aussi bien la communication par le bus de terrain que l'alimentation électrique du module fonctionnel (7), l'au moins un élément fonctionnel (8) étant un moteur, un capteur ou une disposition de capteurs, un élément d'éclairage, une caméra, une machine de travail, un élément de saisie, un affichage ou un haut-parleur et l'interface de communication (13) connectée à l'unité de calcul (10) en vue de la transmission de données et servant à la connexion à un réseau de communication ainsi que l'interface électrique (12) connectée électriquement à une alimentation électrique (11) de l'unité de calcul (10) et servant à la connexion à un réseau électrique local étant réunies en une interface hybride commune (14), de préférence une interface d'alimentation électrique par Ethernet (PoE), **caractérisé en ce que** le boîtier (1) est conformé comme un profilé polygonal allongé (4) renfermant une cavité intérieure, dans laquelle le module de base (9) fixé sur une plaque de base (2) dépasse à son extrémité et qu'il ferme au moyen de la plaque de base (2), l'au moins un élément fonctionnel (8) étant fixé à une plaque de couvercle (3), le module fonctionnel (7) dépassant à son extrémité dans la cavité intérieure du profilé polygonal (4) et fermant celle-ci au moyen de la plaque de couvercle (3) et le profilé polygonal (4) présentant sur sa paroi de circonférence au moins une rainure allongée (5) avec une contre-dépouille dans laquelle peut être introduit, pour fixer l'appareil de terrain (6) sur un dispositif portant, un coulisseau dans lequel une vis peut être serrée et le boîtier peut être fixé au dispositif portant.

2. Appareil de terrain selon l'une des revendications précédentes, **caractérisé en ce que** le boîtier (1) est associé à une interface de réseau (16) connectée à l'unité de calcul (10) en vue de la transmission de données et servant à la connexion à un réseau de communication externe, ainsi qu'un branchement de réseau (17) connecté électriquement à l'alimentation électrique (11) de l'unité de calcul (10) et servant à la connexion à un réseau électrique externe, un convertisseur de tension (18) étant intercalé entre le branchement de réseau (17) et l'alimentation électrique (11) de l'unité de calcul (10).

3. Appareil de terrain selon l'une des revendications précédentes, **caractérisé en ce que** des microprocesseurs (19) du module de base (9) et/ou du module fonctionnel (7) sont reliés à la plaque de base (2) et/ou à la plaque de couvercle (3) de manière conductrice thermique et la plaque de base (2) et/ou la plaque de couvercle (3) sont reliées pour leur part au profilé polygonal (4) de manière conductrice thermique.

4. Appareil de terrain selon l'une des revendications précédentes, **caractérisé en ce que** le boîtier (1) est associé à des microprocesseurs (19) qui sont reliés au profilé polygonal (4) en intercalant une couche conductrice thermique.
